Europäisches Patentamt

European Patent Office

Office européen des brevets

(11) Veröffentlichungsnummer: **0 123 093**

**A1**

(12) **EUROPÄISCHE PATENTANMELDUNG**

(21) Anmeldenummer: **84102643.8**

(22) Anmeldetag: **10.03.84**

(51) Int. Cl.³: **H 01 L 29/92**
H 01 L 27/06, H 01 L 21/265

(30) Priorität: 15.03.83 GB 8307145
19.05.83 GB 8313853

(43) Veröffentlichungstag der Anmeldung:
31.10.84 Patentblatt 84/44

(84) Benannte Vertragsstaaten:
DE FR IT NL

(71) Anmelder: Deutsche ITT Industries GmbH
Hans-Bunte-Strasse 19 Postfach 840
D-7800 Freiburg(DE)

(84) Benannte Vertragsstaaten:
DE

(71) Anmelder: ITT INDUSTRIES INC.
320 Park Avenue
New York, NY 10022(US)

(84) Benannte Vertragsstaaten:
FR IT NL

(72) Erfinder: Mun, Joseph
204A Old Road
Old Harlow Essex(GB)

(72) Erfinder: Barker, Graeme Kenneth
5 Glebe End
Elsenham Essex(GB)

(72) Erfinder: Badawi, Mohamed Hani
3 Rainsford Road
Stansted Essex(GB)

(74) Vertreter: Morstadt, Volker, Dipl.-Ing.
c/o Deutsche ITT Industries GmbH Patent/lizenzabteilung
Postfach 840 Hans-Bunte-Strasse 19
D-7800 Freiburg/Brsg.(DE)

(54) Schottky-Diode, integrierte Schaltung mit Schottky-Diode und Verfahren zur Herstellung derselben.

(57) Eine im Hochfrequenzbereich, z.B. im Milimeterwellen-bereich arbeitende Halbleiterstruktur, z.B. eine Schottky-Dioden-struktur enthält eine vergrabene Schicht (29) aus $n^+$-leitendem Material und eine Oberflächenschicht (20) aus schwach n-dotiertem Material, auf der ein Schottky-Kontakt (25) angeordnet ist. Die $n^+$-leitende Schicht sorgt für einen niedrigen Reihenwiderstand, so daß bei hohen Frequenzbereichen gearbeitet werden kann. Die Struktur ist mit dem Herstellverfahren für MES-Feldeffekttransistoren kompatibel und läßt sich somit in eine integrierte Schaltung einbauen.

Fig.4

J.Mun et al 8-1-1

Fl 1214 EP
07. März 1984
Dr.Rl/bk

Halbleiterbauelement  BEZEICHNUNG GEÄNDERT
siehe Titelseite

Die Prioritäten der Anmeldungen Nr. 8307145  vom
15. März 1983  und Nr. 8313853  vom 19. Mai 1983,beide
in Großbritannien,werden beansprucht.

Die Erfindung betrifft Halbleiterdioden und insbesondere
integrierbare Schottky-Dioden mit niedrigem Widerstand,
die bei Millimeterwellenfrequenzen betrieben werden
können.

Mit der steigenden Verwendung von Schaltungen, die im
Millimeterwellenbereich arbeiten, z.B. für Fernmeldezwecke,
ergibt sich ein Bedarf an Mischerdiodenstrukturen,die
in diesen Frequenzbereichen wirkungsvoll arbeiten. Den
herkömmlichen Bauelementen haftet der Nachteil an, daß
sie einen relativ hohen Reihenwiderstand und/oder eine
verhältnismäßig hohe parasitäre Kapazität aufweisen;
beides kann ernsthaft den Betrieb im hohen Frequenzbereich beeinträchtigen. Es wurden deshalb eine ganze
Reihe von Versuchen zur Schaffung von Diodenstrukturen
unternommen, denen diese Nachteile nicht anhaften, aber
keine dieser Strukturen ist ohne weiteres mit den
MESFET-Herstellungsverfahren kompatibel, die bei der
Herstellung von integrierten Schaltungen verwendet werden,
die im Millimeterwellenfrequenzbereich arbeiten.

Die in den Ansprüchen gekennzeichnete Erfindung dient der
Lösung dieser Problemstellung; die Aufgabe der Erfindung
besteht demnach darin, eine entsprechende Diodenstruktur,
die der genannten Voraussetzung entspricht, sowie ein
Verfahren zu deren Herstellung anzugeben.

Gemäß einem Merkmal der vorliegenden Erfindung wird eine in einem Verbindungshalbleiter-Substrat angeordnete Schottky-Diodenstruktur geschaffen, die aus einer vergrabenen Schicht aus $n^+$-leitendem Material besteht, das von einer Oberflächenschicht aus schwach dotiertem n-leitendem Material überlagert ist, wobei ein Schottky-Kontakt an der Oberfläche und ein ohmscher Kontakt an der vergrabenen Schicht angeschlossen sind.

Die Erfindung beschreibt ferner die Schaffung einer integrierten Schaltung, die im Millimeterwellenbereich arbeitet und einen Schottky-Feldeffekttransistor (MES-Feldeffekttransistor) und eine Schottky-Diodenstruktur umfaßt, die in einem Verbindungshalbleiter-Substrat ausgebildet sind. Die Schaltung enthält eine vergrabene Schicht aus $n^+$-leitendem Material, überlagert von einer Oberflächenschicht aus schwach n-dotiertem Material, einem Schottky-Diodenkontakt und einem Schottky-Gate-Kontakt, angeordnet auf der Oberfläche, sowie ferner erste, zweite und dritte ohmsche Kontakte an der vergrabenen Schicht, die den ohmschen Kontakt der Diode sowie die Source- und Drain-Kontakte des MES-Feldeffekttransistors darstellen.

Die Erfindung gibt ferner ein Verfahren zur Herstellung einer Halbleiterstruktur, eingeschlossen eine Schottky-Diode, in einem Verbindungshalbleiter-Substrat an, wobei das Verfahren die selektive Implantation von Ionen hoher Energie in das Substrat unter Ausbildung einer vergrabenen Schicht von $n^+$-leitendem Material enthält, ferner die Implantation von Ionen mit niedriger Energie zur Ausbildung einer Oberflächenschicht aus schwach n-leitendem Material, sowie die Ausbildung eines Schottky-Kontaktes auf der Oberflächenschicht und eines ohmschen Kontaktes an der vergrabenen Schicht.

Ein geeignetes Verbindungshalbleitermaterial ist Galliumarsenid, da es einen zur Erzeugung hoher Frequenzen geeigneten Bandabstand und entsprechende Trägerbeweglichkeit aufweist; die bevorzugte Herstellungstechnik wendet die Implantation von doppelt geladenen n-dotierten Ionen, z.B. Silicium, bei hoher Energie an, um die hochdotierte vergrabene Schicht vom $n^+$-Leitungstyp zu erzeugen. Eine anschließende Implantation mit niedriger Energie liefert eine schwach dotierte n-leitende Oberflächenschicht, auf der dann der Schottky-Kontakt der Diode ausgebildet wird. Vorteilhafterweise läßt sich durch die selektive Implantation der vergrabenen Schicht eine Struktur mit niedriger parasitärer Kapazität und demgemäß verbessertem Verhalten bei hohen Frequenzen erzielen. Die Technik ist mit dem gegenwärtigen MESFET-Prozeß kompatibel und somit insbesondere zur Herstellung von integrierten Schaltungen geeignet, die im Millimeterwellenbereich arbeiten.

Die Erfindung wird nun anhand der Figuren der Zeichnung näher erläutert.

Fig. 1 bis 4    sind Schnittansichten, die die einzelnen Herstellungsschritte einer Halbleiterstruktur, eingeschlossen eine Schottky-Diode, zeigen, und

Fig. 5          zeigt den Grundriß einer Schottky-Diode nach Fig. 4.

Die Schottky-Diode ist in einem Verbindungshalbleiter-Substrat ausgebildet, vorteilhafterweise als Teil einer integrierten Schaltung. Zur Erläuterung wird lediglich die Herstellung einer Diode und eines daneben liegenden Transistors (MESFET) gezeigt.

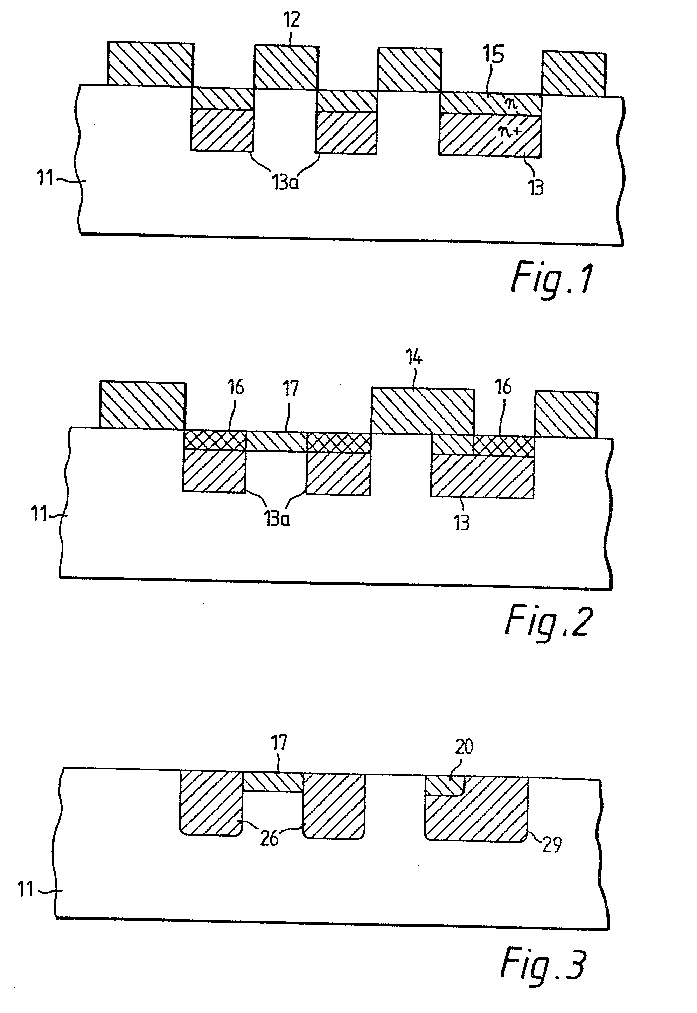

In den Fig. 1 bis 4 ist das Verbindungshalbleiter-Substrat 11 (Fig.1) mit der Maske 12 versehen und wird dann dem Strahl von Dotierionen hoher Energie zur Ausbildung einer vergrabenen $n^+$-leitenden Schicht aus den Zonen 13 und 13a ausgesetzt. Das Substrat besteht charakteristischerweise aus Galliumarsenid und das Dotiermittel aus Silicium, das aufgrund seiner großen Eindringtiefe bevorzugt wird. Mit doppelte geladenen Siliciumionen und einer Beschleunigungsspannung von 200 V, entsprechend einer Energie von 400 KeV, läßt sich eine Eindringtiefe von 0,5 bis 0,6 mm in dem Galliumarsenid-Substrat erzielen. Unter derartigen Bedingungen wurde gefunden, daß mit einer Dosis von $10^{14}$ Ionen/cm² ein Dotierpegel von $10^{18}$ Siliciumatomen/cm³ erreicht werden kann, bei einer Oberflächenkonzentration von etwa $10^{17}$ Atome/cm³. Eine derartige Schicht kann durch einen Schottky-Kontakt vollständig ausgeräumt werden. In der Praxis erweist es sich als schwierig, Dotierpegel über $2 \times 10^{18}$ Atome/cm³ zu erreichen.

Als vergrabene Schicht ist die $n^+$-leitende Schicht von der Halbleiteroberfläche durch die schwach dotierte Oberflächenschicht 15 getrennt. Deren Stärke ist selbstverständlich eine Funktion der Implantationsenergie und beträgt 0,1 bis 0,2 µm.

Nach der Implantation der vergrabenen Schicht 13 wird die Maske 12 entfernt und eine zweite Maske 14 (Fig. 2) aufgebracht. Eine Implantation von z.B. Silicium mit niedriger Energie (80 KeV, $4 \times 10^{12}$ Atome/cm³) bewirkt einen Anstieg des Dotierpegels der Oberflächenschicht 15 in den Bereichen 16, in denen ohmsche Kontakte auszubilden sind. Gleichzeitig legt der Dotiervorgang den Kanal des Feldeffekttransistors fest (schwach n-leitende Zone 17).

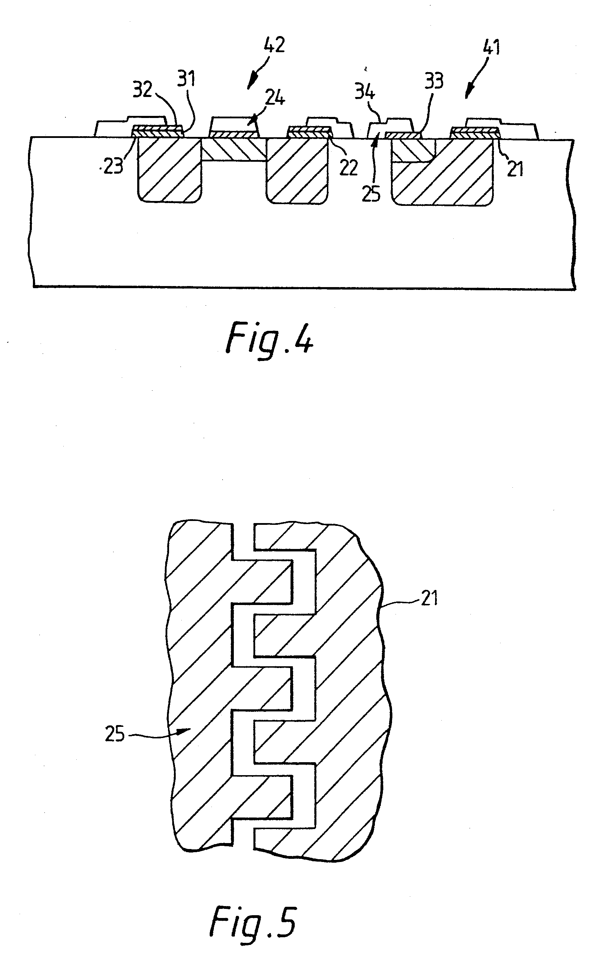

Die Maske 14 wird entfernt und die Struktur zur Aktivierung des implantierten Bereiches getempert. Man erhält die in Fig. 3 gezeigte Struktur mit zwei hochdotierten $n^+$-leitenden Zonen 26, getrennt durch die schwach n-leitende Zone 17, sowie eine weitere $n^+$-leitende Zone 29 mit einer schwach n-dotierten Oberflächenzone 20. Die ohmschen Kontakte 21, 22 und 23 (Fig. 4) werden danach an den $n^+$-leitenden Zonen unter Ausbildung der entsprechenden ohmschen Kontakte der Schottky-Diode 41 und der Source- und Drain-Kontakt des MOS-Feldeffekttransistors 42 angebracht. Die Kontakte bestehen aus einer unteren Schicht 31 aus Gold/Germanium-Legierung und einer Oberschicht 32 aus Nickel.

Die Schottky-Kontakte 24, 25 bestehen aus einer Schicht 33 aus Chrom und einer Oberschicht 34 aus Gold und sind an die schwach n-dotierten Zonen unter Ausbildung des entsprechenden Gate des MES-Feldeffekttransistors und der Schottky-Kontakte der Diode angebracht. Der Schottky-Kontakt 25 liegt auch über einen nichtimplantierten Bereich unter Ausbildung von Zwischenverbindungen und passiven Mikrowellenkomponenten wie Filter, Koppler und Übertragungslinien.

Die Struktur der Schottky-Diode ist in Fig. 5 gezeigt. Man erkennt, daß der ohmsche Kontakt 20 und der Schottky-Kontakt 25 nebeneinander auf dem Halbleitersubstrat angeordnet sind. Vorteilhafterweise sind die Kanten der Kontakte als ineinandergreifende Finger ausgebildet. Dies bewirkt ein Aufbrechen der Diodenstruktur in eine Vielzahl von parallel miteinander verbundenen kleineren Dioden, wodurch wesentlich die Parallelkapazität des Bauelements verringert wird. Die Diodenstruktur umfaßt charakteristischer Weise wenigstens 10 dieser kleineren Dioden, von denen jede eine Größe von ca. 1 x 2 µm aufweist. Da die vergrabene, den Strompfad durch die Diode bildende $n^+$-leitende Schicht eine relativ hohe Leitfähigkeit besitzt, ist der Reihenwiderstand der Diode gering, so daß bei hohen Frequenzbereichen gearbeitet werden kann. Die vorhergehende Beschreibung betrifft die Herstellung einer Diodenstruktur als Teil einer integrierten Schaltung, man kann jedoch die Diode auch als diskretes Bauelement herstellen. Ebenso kann anstelle von Galliumarsenid als bevorzugtes Material jeder andere beliebige Verbindungshalbleiter verwendet werden.

0123093

J. Mun et al 8-1-1 Fl 1214 EP

In einem besonders vorteilhaften Ausführungsbeispiel der Erfindung ist das Substrat 11 mit einer dünnen, $3 \times 10^3$ bis $5 \times 10^3$ nm, vorzugsweise $4 \times 10^3$ nm starken Oberflächenschicht aus Titan überzogen. Die Photolackmaske 12 ist dann auf dieser Schicht ausgebildet. Zweck der Titanschicht ist die Verhinderung jeder Verunreinigung, die aus dem Kontakt der Photomaske 12 mit der Halbleiteroberfläche resultieren könnte. Die Titanschicht wird durch Aufdampfen aufgebracht und wird nach der Implantationsstufe durch herkömmliches Naßätzen entfernt.

J. Mun et al 8-1-1

Fl 1214 EP
07. März 1984
Dr.Rl/bk

Patentansprüche

1. Schottky-Diode ausgebildet in einem Verbindungshalbleiter-Substrat, gekennzeichnet durch eine vergrabene Schicht (29) aus $n^+$-leitendem Material mit einer Oberflächenschicht (20) aus schwach n-dotiertem Material, wobei die Oberflächenschicht (20) mit einem Schottky-Kontakt (25) und die vergrabene Schicht mit einem ohmschen Kontakt (21) versehen ist.

2. Diodenstruktur nach Anspruch 1, gekennzeichnet durch eine Vielzahl von gleichartigen, parallel angeordneten, miteinander verbundenen Dioden.

3. Diodenstruktur nach Anspruch 1 oder 2, dadurch gekennzeichnet, daß die vergrabene Schicht (29) durch Implantation von Siliciumionen hergestellt ist.

4. Diodenstruktur nach Anspruch 3, dadurch gekennzeichnet, daß der Dotierpegel $10^{18}$ bis $2 \times 10^{18}$ Atome/cm³ beträgt.

5. Integrierte Schaltung mit einem Schottky-Feldeffekttransistor und eine Schottky-Diodenstruktur, ausgebildet in einem Verbindungshalbleiter-Substrat, gekennzeichnet durch vergrabene $n^+$-leitende, durch eine schwach n-dotierte Oberflächenschicht (17) getrennte Schichten (26) und eine vergrabene $n^+$-leitende Schicht (29) mit einer schwach n-dotierten Oberflächenschicht (20), wobei Schottky-Kontakte an den Oberflächenschichten angeordnet sind,

J. Mun et al 8-1-1                                    Fl 1214 EP

und      , daß erste, zweite und dritte ohmsche
Kontakte (21, 22, 23) an den vergrabenen Schichten angebracht sind, die den ohmschen Kontakt der Diode (41)
und die Source- und Drain-Kontakte des MES-Feldeffekttransistors (42) darstellen.

6. Integrierte Schaltung nach Anspruch 5, gekennzeichnet,
   durch mehrere Diodenstrukturen nach einem der
   Ansprüche 1 bis 4.

7. Verfahren zur Herstellung von Halbleiterstrukturen in
   einem Verbindungshalbleiter-Substrat, gekennzeichnet,
   durch die folgenden Verfahrensschritte:
   - selektives Implantieren von Ionen hoher Energie in
     das Substrat  unter Ausbildung einer vergrabenen
     $n^+$-leitenden Schicht,
   - Implantieren von Ionen geringerer Energie unter Ausbildung einer Oberflächenschicht aus schwach n-dotiertem Material,
   - Anbringen eines Schottky-Kontaktes auf der Oberflächenschicht und eines ohmschen Kontaktes an der vergrabenen
     Schicht.

8. Verfahren nach Anspruch 7, dadurch gekennzeichnet, daß
   das Substrat aus Galliumarsenid besteht.

9. Verfahren nach den Ansprüchen 7 und 8, dadurch gekennzeichnet, daß die energiereichen Ionen doppelt geladene Siliciumionen sind, die bis zur Tiefe von 0,5
   bis 0,6 µm implantiert werden.

10. Verfahren nach einem der Ansprüche 7 bis 8, dadurch gekennzeichnet, daß auf dem Halbleitersubstrat ein Titanfilm von 3 bis 5 x $10^3$ µm und darauf eine Photolackschicht
    aufgebracht wird.

Fig.1

Fig.2

Fig.3

0123093

Fig.4

Fig.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X,P | EP-A-0 081 423 (THOMSON-CSF)<br>* Seite 3, Zeilen 9-35; Figur 1 * | 1 | H 01 L 29/92<br>H 01 L 27/06<br>H 01 L 21/265 |
| A | EP-A-0 034 729 (SIEMENS)<br><br>* Anspruch 3; Seite 4, Zeile 24 - Seite 5, Zeile 15 * | 1,3,5,<br>8 | |
| A | US-A-4 301 233 (CALVIELLO)<br>* Spalte 4, Zeilen 26-31; Zeile 66 - Spalte 5, Zeile 3; Figuren 4, 5 * | 1,2,6 | |
| A | DE-B-2 543 654 (SIEMENS)<br>* Ansprüche 1-4; Spalte 3, Zeilen 12-33; Spalte 4, Zeilen 27-32; Figur 2 * | 7,8 | RECHERCHIERTE SACHGEBIETE (Int. Cl. ³) |
| A | RCA REVIEW, Band 42, Nr. 4, Dezember 1981, Princeton, USA L.C. UPADHYAYULA et al. "GaAs integrated circuit development for gigabit-rate signal processing", Seiten 522-541<br>* Seiten 530-534; Figur 2 * | 5 | H 01 L 21/265<br>H 01 L 27/06<br>H 01 L 29/91 |
| A | APPLIED PHYSICS LETTERS, Band 30, Nr. 7, 1. April 1977, New York, USA D.H. LEE et al. "Ion-implanted silicon profiles in GaAs"<br>* Seiten 327-329 * | 9 | |

--- -/-

Der vorliegende Recherchenbericht wurde für alle Patentansprüche erstellt.

| Recherchenort | Abschlußdatum der Recherche | Prüfer |
|---|---|---|
| BERLIN | 22-06-1984 | ROTHER A H J |

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | EINSCHLÄGIGE DOKUMENTE | | Seite 2 |
| A | IEEE TRANSACTIONS ON ELECTRON DEVICES, Band ED-28, Nr. 2, Februar 1981, New York, USA J. CLIFTON et al. "High-performance quasi-optical GaAs monolithic mixer at 110 GHz", Seiten 155-157 * Seite 155; Figur 4 * ----- | 1 | |

RECHERCHIERTE
SACHGEBIETE (Int. Cl. ³)

Der vorliegende Recherchenbericht wurde für alle Patentansprüche erstellt.

| Recherchenort | Abschlußdatum der Recherche | Prüfer |
|---|---|---|
| BERLIN | 22-06-1984 | ROTHER A H J |